# EUROPEAN PATENT APPLICATION

(11) **EP 3 550 616 A1**
(43) Date of publication of application: **09.10.2019**
(21) Application number: 19425024.7
(22) Date of filing: 04.04.2019
(51) Int. Cl.: H01L 31/05

(54) **EFFECTIVE POWER BOOSTER PANEL FOR PHOTOVOLTAIC PLANTS**

(30) Priority: 04.04.2018 IT 201800004185
(71) Applicant: Badini, Angelo, 00072 Ariccia (IT)
(72) Inventor: Badini, Angelo, 00072 Ariccia (IT)

(57) **Abstract**

Photovoltaic panel (1) including a plurality of strings (1₁; ...; 1₆) including photovoltaic cells (3₁; ...; 3₁₀) electrically connected in series with each other through connecting busbars (7); each one of which strings has two poles, respectively a positive (+) one and a negative (-) one, respectively provided by free terminals of said busbars by opposite parts on said strings and including insertion means (9) for cables for the electric connection of the panel to utilizing devices. Each one of the strings is electrically disconnected from the other strings. The insertion means (9) for input and output connection cables provide a connection (1₁₁, 1₁₂; ...; 1₆₁, 1₆₂) with each one of the poles of each one of said strings; the strings may be electrically connected to loads independently of each other.

## Description

This invention relates to a photovoltaic panel according to the preamble of Claim 1.

It also relates to an electric power supply photovoltaic plant.

A photovoltaic cell performs a direct conversion of electromagnetic radiation energy of light through photovoltaic effect, i.e. the appearance of an electric potential difference across it when it, in an unpolarized state, is exposed to the interaction with electromagnetic radiation of light, particularly sunlight. A cell includes a semiconductor material platelet, having an upper negative pole face, whereon electrically conductive stripes are applied, and an opposite, positive pole lower face.

A photovoltaic panel includes a plurality of strings of said side-by-side assembled photovoltaic cells. The cells in each string are series-electrically connected through connecting busbars, and each one of the strings has a positive pole (+) electric end and a negative pole (-) electric end, respectively provided by free terminals of said busbars on end cells of said strings. The busbars for series-connecting contiguous cells in each string are each one soldered by a half thereof to the negative pole upper face of a cell, by the other half thereof to the positive pole lower face of a contiguous cell in the string. The strings are electrically series-connected with each other through corresponding connections. The panel includes a connection box, assembled on the rear thereof, which an input cable ends in and an output cable comes out for the connection to a utilizer.

The problem is connected with existing photovoltaic plants that the effective power delivered by the panels that compose them undergoes a sensible decrease when the temperature of the panels grows and because of an ageing phenomenon.

It is the object of this invention to provide a solution to such a problem. Such an object is reached, according to the teaching of this invention, by envisaging providing a photovoltaic panel wherein the single component strings are not connected in series with each other, as in a panel of known art, and are provided with means for the electric connection of input and output cables to the positive and the negative output of each one of them. Such a panel may be manufactured through sectioning cuts of the electric series connections of the strings of a commercially available panel. Therefore each panel, a commercial one, is connected to the inventive panel in series with each string thereof, and so the inventive panel works as an effective peak power booster of all of the panels that find themselves connected thereto.

In a practical example, six traditional panels that should provide a peak power of 250 W/panel x 6 W = 1500 W actually provide 1176 W. In fact with the heating of the panel under an inserted load one lowers to 28 V, so that effective power is 28 V x 6 panels x 7 A = 1176 W. With an inventive panel, instead, one achieves 36 V x 6 x 7 A = 1512 effective watt.

So, a photovoltaic plant advantageously may comprise a lesser number of panels and so be highly competitive. With the inventive panel a better yield of the panels at high temperatures is achieved, and with veiled Sun it allows a faster start of the inverter as it works at a higher voltage.

With an inventive panel in a long line where a loss of voltage and current is undergone, the voltage and current drop may by raised again, bringing the plant again to its peak yield.

The inventive panel may be inserted in old obsolete photovoltaic plants to be scrapped having too a low power, bringing the same photovoltaic field again to the initial peak efficiency of the field. Whereby it will be no more necessary to support scrapping expenses, because a pre-existing old plant is revived.

The inventive panel may also be advantageously connected as a voltage booster in a wind farm to compensate for power lowerings of wind vanes.

This invention further puts the object itself of solving, in the photovoltaic plants that put on a direct current electric grid on electric power transmission lines through an inverter, the objective technical problem consisting in the voltage drop and the current loss along the transmission lines. Such a problem is solved by this invention through the teaching of inserting a string or a combination of series and/or parallel connections of strings of the inventive panel, through the free outputs of the strings themselves, in series on the output conductor of a transmission line, in correspondence with an end input tract of the output conductor itself in the inverter, raising the voltage and the current again.

The advantages achieved with the inventive teaching are very sensible: one may use cables having a lesser section, with economic advantage; and one may compensate for the performance drop of the cables which owing to ageing have lost a part of their conductivity.

This is to say, the photovoltaic panel of this invention may be used as an booster of the voltage of photovoltaic panelings. This also involves the advantage of being able to reduce the number of photovoltaic panels, the performances of the plant being equal.

This invention further envisages that at the output of each string or combination of series and/or parallel connections of strings of each panel it is possible to insert a DC-DC direct current-direct current voltage booster module to further raise the voltage for further utilizing loads, such as, for non-limiting example, light emitting diode head lamps or an AC-DC alternating current-direct current inverter.

This invention further puts the object itself of solving an objective technical problem in a storage battery island electric power generating photovoltaic plant, including photovoltaic panels and a group of storage batteries connected in series with each other, consequent to the fact that in the state of the art the group of storage batteries connected in series with each other is supplied by the electric power generating means, i.e. by the assembly of the photovoltaic paneling, in turn through a series connection. Such a problem is that the voltage across the whole paneling being so applied to the series connection of the storage batteries, the batteries themselves are all charged in series, in an undistinctive manner among the batteries. But the batteries will be not uniform as regards the electric resistance and the electric characteristics thereof and therefore there will be some batteries which will turn out to be more/less charged than other ones. Namely, the series connection does never make all the batteries put in series to be fully charged, because each single battery for its internal resistance and its own individual electrical characteristics does not allow a full charging thereof, specifying that if one analyses battery by battery, one finds that some batteries are at their optimum power and other batteries are not at their optimum power, bringing the plant to an unbalancing, with an effect which is more apparent when one has the total discharging of the batteries.

Moreover, this invention puts the object itself to remove the shortcoming that the use is necessary of charge regulators for the batteries.

Moreover, with the panelings and the connections of traditional plants it is not possible to charge the batteries and compensate for the discharging of the batteries in short times. This invention puts the object itself of providing a plant wherein the batteries may be charged in times sensibly shorter than in traditional plants.

Such objects are reached by this invention through the contrivance, in a storage battery island electric power generating photovoltaic plant, including photovoltaic panels and a group of storage batteries connected in series with each other, of realizing the photovoltaic panels respectively as the aforementioned inventive photovoltaic panels; and of supplying each one of the batteries with electric power individually by a string or by a combination of series and/or parallel connections of strings of one of the photovoltaic panels themselves of the plant. Namely, one supplies voltage and current to each battery individually excluding the series-circuit of the batteries themselves. Through the aforementioned series/parallel connections it is possible to add the voltages/currents of the aforementioned strings of an inventive panel, which, so, is suitable to operate as a multivoltage-multicurrent panel to charge the batteries to their optimum charge voltage. In an inventive plant each photovoltaic panel is an individual generator for one battery, suitable for providing thereto a charge greater than the discharge of the same in the progress of its operation.

With the inventive contrivance one has sensible advantages: an extended useful life of the batteries; it turns out to be possible to sensibly reduce the number of photovoltaic panels, the delivered power being equal and to put more power on the grid by exploiting the inverter itself; the operativeness of the plant turns out to be possible even in the lack of one or more batteries, or if a battery in the course of the day should go to failure because it compensates for the panel itself at least till there is a sufficient sunlight by virtue of the power delivered by the paneling itself; charge regulators are no more necessary, because by suitably selecting the sum of voltages and/or currents by means of the aforementioned series/parallel connections of panel strings, the possibility is given to have a charging voltage across each battery which is not higher that the rated peak one declared by the manufacturer of the battery itself.

An inventive island photovoltaic plant has the advantage that it may deliver a very high power with a number of photovoltaic panels sensibly reduced compared with the one necessary with a traditional plant.

Therefore, it is the subject-matter of this invention a photovoltaic panel according to appended independent Claim 1.

It also forms the subject-matter of this invention a kit including said photovoltaic panel, according to appended independent Claim 4.

Further subject-matter of this invention is formed by electric power generating plants including said kit, according to appended independent Claims 5, 6 and 7.

It is further subject-matter of this invention an electric power generating photovoltaic plant according to appended independent Claim 9.

It is further subject-matter of this invention a storage battery island electric power generating photovoltaic plant according to appended independent Claim 10.

Preferred embodiments are set forth in dependent claims.

The panel of this invention differentiates from other ones because it provides the possibility of having a variable voltage and current according to the discretion of the user who is able to set all the types of voltage required by any apparatus. For instance by bringing the panel to a voltage of 5 volt and adding all the various outputs thereof one has a current of 60 ampere based on the used cell. Whereby with these high currents one may use a DC-DC module and bring the voltage to a required value having very high performances even with the conversion drop. The panel of this invention may as well be used for a low voltage electric motor, such as for instance a marine motor, giving the possibility of travelling only exclusively with the inventive finding itself, without the aid of a battery or charging the same together. By programming the panel at a 12 volt voltage and adding the currents of the single strings. The inventive panel is very valid for solar plants or lightning led headlamps, where the performances thereof allow the charge control box and the conversion inverter not to be used, but only exclusively the panel itself with only batteries to be used, playing with the power and the setting thereof, giving the possibility of having a higher load and of having a greater efficiency in terms of illumination hours. With led illumination as well it is able in the course of the day to provide illuminating power and charge the battery at one time, having the outputs of the same divided. The batteries will be used during night hours. The inventive panel used on central processing units of large servers allow to have a very high power and if we add various panels having the same voltage we shall have very high powers at a low voltage of 5 volt, saving on conversions and stabilizers. The above only cited as a matter of example. A single panel is able to provide all available voltages from 3 volt to 48 volt.

This invention will be fully understood based on the following detailed disclosure of preferred embodiments thereof, only given as a matter of example, absolutely not of restriction, referring to the annexed drawings, wherein:
- FIGURE 1 is a front view of an inventive photovoltaic panel;
- FIGURE 2 is a rear view of an inventive photovoltaic panel with an equipment of connecting cables;
- FIGURE 3 is a schematic view of a traditional photovoltaic plant;
- FIGURE 4 is a schematic view of a storage battery island photovoltaic plant in which an inventive power booster is utilized;
- FIGURE 5 is a schematic view of a photovoltaic plant on the electric grid in which an inventive power booster is utilized;
- FIGURE 6 is a schematic view of a wind farm that utilizes an inventive voltage booster panel;
- FIGURE 7 and FIGURE 8 illustrate an electric power generating plant connected to the electric power distributing grid through an inverter in which an inventive voltage booster panel is inserted;
- FIGURE 9 illustrates a storage battery island photovoltaic electric power generating plant according to this invention.

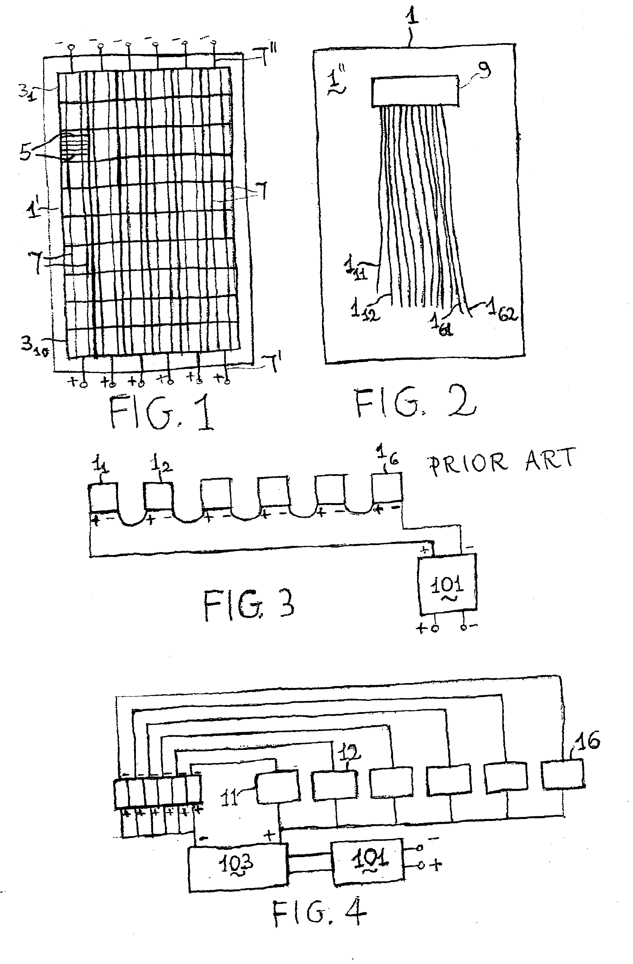

As illustrated in FIGURE 1, this invention is a photovoltaic panel 1, having a front face 1' to be exposed to the Sun and a rear face 1", assembled through placing strings of photovoltaic cells side by side. For instance the panel may include six strings 1₁; ...; 1₆ of ten photovoltaic cells 3₁; ...; 3₁₀. Each cell has an upper negative pole face, to be exposed to the Sun, whereon electrically conductive stripes 5 are applied, and an opposite lower positive pole face, and the cells in each string are electrically connected in series with each other through connecting busbars 7. Each one of the strings has a positive pole electric end and a negative pole electric end, respectively provided by free terminals 7'; 7" of the outgoing busbars on extremal cells 3₁; ...; 3₁₀ of strings 1₁; ...; 1₆.

Preceptively, each one of the strings is electrically disconnected from the other strings.

The panel may be manufactured through sectioning of the series electric connections between the strings present in a commercial panel.

As illustrated in FIGURE 2, on rear face 1" of the panel an electric connection box 9 is provided, which includes one or more pairs of terminals forming electric insertion means in each one of the poles of each one of the strings of a plurality of pairs of an input cable and of an output cable 1₁₁, 1₁₂; ...; 1₆₁, 1₆₂ for electrically connecting the panel to utilizing devices. More than a pair of terminals may be provided for at least one string, particularly for all of the strings, to increase the number of sectionings of the output of the panel and so the number of cables that may be connected. In the example of FIGURE 2 twelve cables are dealt with, but for instance even twenty-four may be envisaged.

As illustrated in FIGURE 3, in a traditional photovoltaic plant, as a matter of example composed of one panel only composed of six strings 1₁; ...; 1₆, these ones are connected in series to each other and the assembly thereof is in turn connected in series to a direct current-alternating current converter i.e. 'inverter' 101 which puts on the electric distributing grid.

As illustrated in FIGURE 4, in a storage battery island photovoltaic plant, an inventive panel 1 is connected as a main module with each one of strings 1₁; ...; 1₆ in series with respective panels (commercial panels) 1₁, ..., 1₆. The series string-panel connections are in turn connected in parallel with each other and the circuit parallel thereof is connected with the terminals of a storage battery 103 in turn connected with inverter 101 which in turn directly puts on the electric power distributing grid.

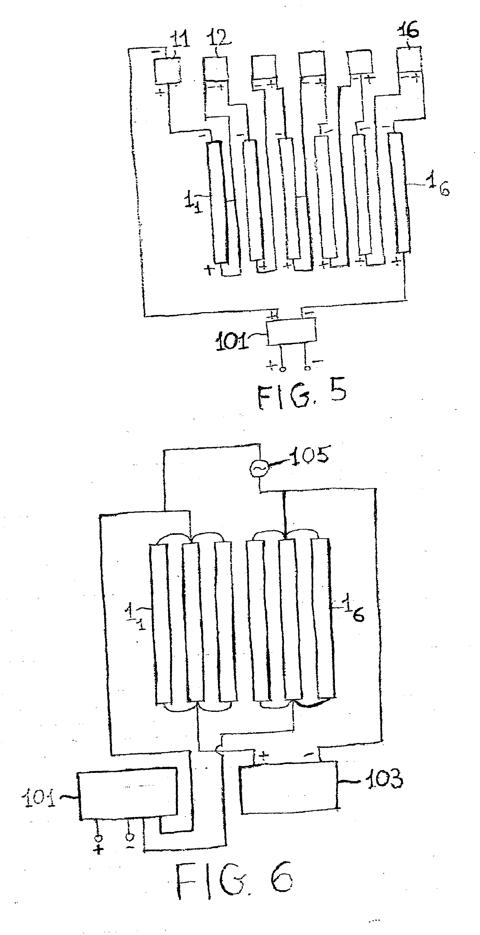

As illustrated in FIGURE 5, in a photovoltaic plant connected in series through inverter 101, an inventive panel 1 is connected as a main module with each one of strings 1₁; ...; 1₆ in series with respective panels (commercial panels) 1₁, ..., 1₆. The series string-panel connections are in turn connected in series with each other and the circuit series thereof is connected with the terminals of inverter 101 which in turn directly puts on the electric power distributing grid.

So, in both the island plant and in the electric grid plant, the efficiency of the paneling is raised, greatly increasing current and voltage output, with considerable results even under poor sunlight.

As illustrated in FIGURE 6, in a plant including a wind generator 105 (or even another kind of generator, such as for instance a turbine one), connected with the electric grid through inverter 101 and with a storage battery 103, an inventive panel 1 is connected as a main module with a first assembly of three strings 1₁; ...; 1₃ which have the outputs thereof connected in a parallel connected with inverter 101 and with a storage battery 103 and with a second assembly of three strings 1₄; ...; 1₆ which have the outputs thereof connected in a parallel connected with inverter 101. Wind generator 105 is connected by an end thereof with first string assembly 1₁; ...; 1₃ and by the other end thereof with battery 103. At the moment when the wind turbine does not reach the optimum revolution rate to start delivering power, through the addition of the inventive panel one provides for raising voltage and one goes to exploit the currents of the generator, already high at that low revolution rate, giving the possibility that already at a low revolution rate of the wind turbine it is possible to overcome the voltage threshold necessary for the charging of the batteries or for the putting on the electric grid, raising the lacking voltage with the inventive panel, so making the generator to be working at a low revolution rate too. This takes place because it is possible to wire the inventive panel bringing it to a peak current of 50 A when a traditional panel provides 7 A as a maximum and is not able to support the high currents of wind generators (or other electricity generating assemblies too).

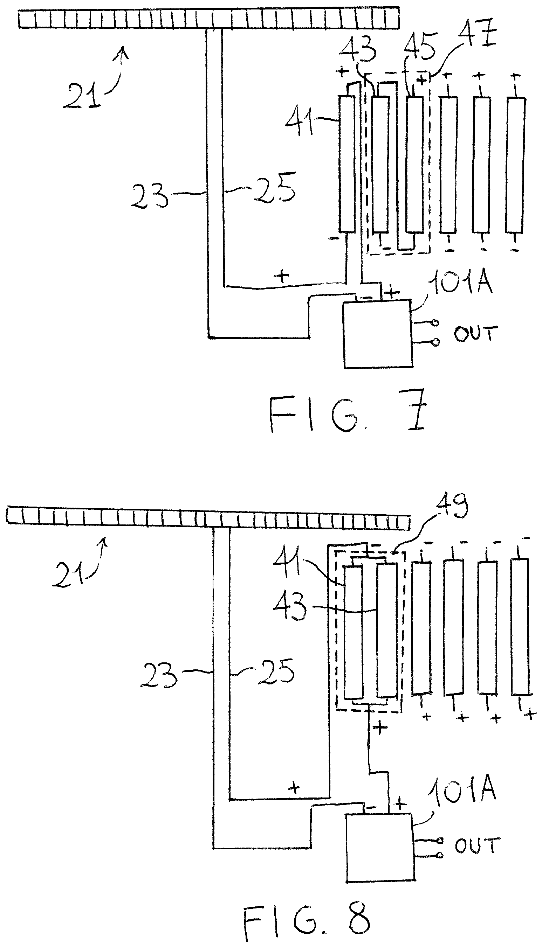

As illustrated in FIGURE 7 and in FIGURE 8, this invention is also an electric power generating photovoltaic plant including a paneling i.e. an assembly of photovoltaic panels 21 connected with the electric power distributing grid on an electric power transmission line including an input conductor 23 and an output conductor 25 through an inverter 101A, wherein a string or a combination of series and/or parallel connections of strings of the inventive panel, through the free outputs of the strings themselves, is inserted in series with the aforesaid output conductor 25 of the aforesaid transmission line in correspondence with an end input tract of output conductor 25 in inverter 101A, upstream of the transmission line itself relative to the paneling. In the example illustrated in FIGURE 7 a single string 41 of the inventive panel is connected with transmission line 25. The panel is able to stand up to six power lines of the photovoltaic field itself at the input of the inverter. If the current turns out to be too low one proceeds with connecting one or more strings of the panel to add currents: in FIGURE 8 the non-limiting example is illustrated of a combination of two panel strings 41; 43 connected in parallel 49, so adding the two currents relevant thereto. The strings may be combined in series-parallel; the combination is illustrated in FIGURE 7 of two strings 43; 45 in series 47, so adding voltages.

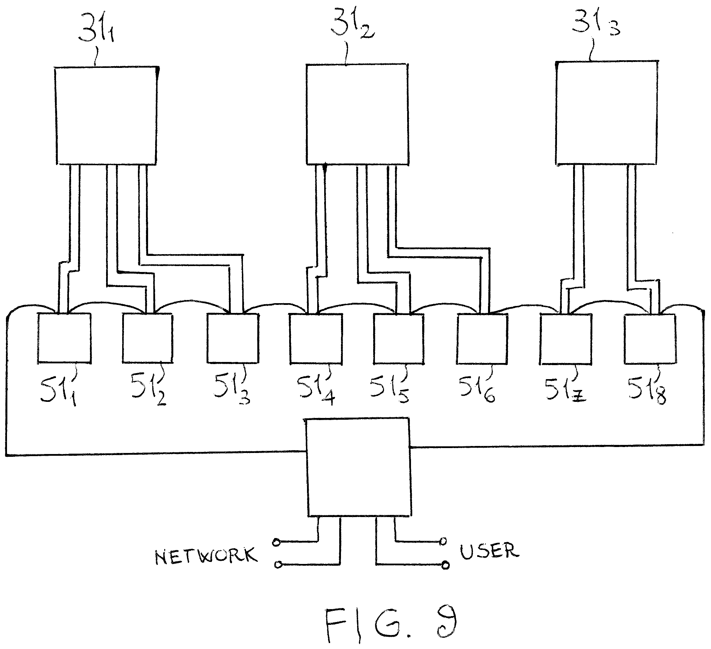

As illustrated in FIGURE 9, this invention is also a storage battery island photovoltaic electric energy generating plant, including photovoltaic panels 31₁; 31₂; 31₃ and an assembly of storage batteries 51₁, 51₂, ..., 51₈ connected in series with each other. The assembly of storage batteries 51₁, 51₂, ..., 51₈ is connected in series with an inverter including a user output and/or an output for a direct putting on the electric power distributing grid. Preceptively, each one of photovoltaic panels 31₁; 31₂; 31₃ is respectively an inventive photovoltaic panel set forth above; and each one of batteries 51₁, 51₂, ..., 51₈ is individually supplied with electric power by a string or by a combination of series and/or parallel connections of strings of one of photovoltaic panels 31₁; 31₂; 31₃ themselves.

### COMPARATIVE EXAMPLE

A traditional photovoltaic plant for 3 kW of total delivered power includes no. twelve photovoltaic panels (and is endowed with an inverter both when putting on the distributing grid and when working as a battery charger). The newest batteries having the best performances commercially available at present are 5 V/100 Ah litium ones. The aforementioned plant includes a pack of no. eight batteries for an overall voltage of 5 V x 8 = 40 V. The battery pack is loaded with the sum of the twelve panels with an amperage of about 3000 Wₚₑₐₖ (delivered power with maximum sunlight and at a temperature not greater than 25 °C)/40 V = 75 A; each single battery is crossed by a current having an intensity of 75 A/8 = 9,375 A per battery. Taking into account that with a total absorption without recharging one has an autonomy of the plant of 5 V x 100 A x 8 = 4000 W/3000 W = 1 h 20 min ca. with fully charged batteries. Having a recharge of 3000 W with no. twelve panels one has to put 9,375 A for each battery; to charge 100 A for each battery 100 A/9,375 A = 10 h 40 min are necessary at the maximum exposure to sunlight (at maximum power) without putting on the grid. By adopting the aforementioned inventive system and wiring the inventive photovoltaic panel one supplies the whole battery pack with no. three 300 W panels only, supplying each single battery on its own, so making all batteries to have the same charge and the same power, without the problem set forth above which is presented by a series-supplied circuit of batteries, as is in a prior art plant. With the inventive panel the problem does no more occur: each individual battery-inventive panel connection may be rendered an optimum one providing an amperage to the battery itself of 20 A each one (10 A provided by the panel through one string, 20 A for instance using two strings, but one could use more of these ones in a way suitable for the power of the battery and for the 5, 10, 12 V battery type which is used) distinctly separately for each cell, based on the wiring of the photovoltaic panel and on the voltages selected for recharging the batteries. With no. three 300 W photovoltaic panels only one has an effective power and an effective lifetime sensibly greater in comparison with traditional plants even with not the greatest exposure to the Sun. This involves a charge which is always perfect, sensibly faster and a more efficient exploitation of the photovoltaic plant. Each battery is charged with 20 A, therefore to charge to 100 Ah 100 Ah/20 A = 5 h are necessary, substantially halving the aforesaid battery recharging time on any battery type and one will be able to dedicate the surplus of the subsequent solar irradiation hours completely to the grid or to the user. With this system it is possible to realize any type of battery island plant or island+grid plant, always having a very lesser quantity of used panels and having all of the batteries always charged and during the day the panels themselves will provide to deliver the power that should be absorbed in case there should be less sunlight, because with this system one is able to always have the battery at the greatest charge thereof and if there are higher peak values of plant absorption the paneling is able to always provide the same greatest power, so making the batteries not impaired during the maximum sunlighting.

This invention has been disclosed and depicted referring to specific embodiments thereof, but variations or omissions may be made, without departing from the scope of protection thereof, which only remains defined by the appended claims.

## Claims

1. Photovoltaic panel (1) including a plurality of strings (1₁; ...; 1₆) including photovoltaic cells (3₁; ...; 3₁₀) electrically connected in series with each other through connecting busbars (7) ; each one of which strings has two poles, respectively a positive (+) one and a negative (-) one, respectively provided by free terminals of said busbars by opposite parts on said strings and including insertion means (9) for cables for the electric connection of the panel to utilizing devices,
**characterized in that**
each one of said strings is electrically disconnected from the other strings;
and **in that**
said insertion means (9) for input and output connection cables include one or more pairs of electric connection terminal (1₁₁, 1₁₂; ...; 1₆₁, 1₆₂) in said poles of each one of said strings (1₁; ...; 1₆); so that said strings may be electrically connected to one or more loads independently of each other.

2. Photovoltaic panel of Claim 1, including more than a pair of electric connection terminals (9) in the poles of at least one of said strings (1₁; ...; 1₆).

3. Photovoltaic panel of Claim 1, manufactured through sectioning of the series electric connections between said strings (1₁; ...; 1₆) of a commercial panel.

4. Photovoltaic panel of Claim 1 wherein further at the output of each string or combination of series and/or parallel connections of strings of each panel it is possible to insert a DC-DC voltage booster module or a DC-AC inverter.

5. Kit including a photovoltaic panel according to Claim 1 and at least a pair of cables (1₁₁, 1₁₂; ...; 1₆₁, 1₆₂).

6. Storage battery island photovoltaic plant, including a photovoltaic panel of Claim 1 connected with each one of said strings (1₁; ...; 1₆) in series with respective panels (11, ..., 16); the so formed string-panel series connections being in turn connected in parallel with each other and the circuit parallel thereof being connected to the terminals of a storage battery (103) in turn connected with an inverter (101) directly putting on the electric power distributing grid.

7. Photovoltaic plant connected with the electric grid through an inverter (101), including a photovoltaic panel of Claim 1 connected with each one of said strings (1₁; ...; 1₆) in series with respective panels (11, ..., 16), the series string-panel connections being in turn connected in series with each other and the circuit series thereof being connected with said inverter (101) which in turn directly puts on the electric power distributing grid.

8. Plant including an electricity generator unit (105), including a panel of Claim 1, wherein outputs of the panel are connected in parallel, adding the electric currents that pass through it.

9. Direct current electric power generating photovoltaic plant including an assembly of photovoltaic panels (21) connected with the electric power distributing grid on an electric power transmission line including an input conductor (23) and an output conductor (25) through an inverter (101A),
**characterized in that**
a string (41) or a combination of series and/or parallel connections of strings (47, 49) of the photovoltaic panel of Claim 1, is inserted in series on said output conductor (25) of said transmission line in correspondence with an end input tract of the output conductor (25) in said inverter (101A), upstream of the transmission line itself relative to said assembly of photovoltaic panels.

10. Storage battery island photovoltaic electric power generating plant, including photovoltaic panels (31₁; 31₂; 31₃) and an assembly of storage batteries (51₁, 51₂, ..., 51₈) connected in series with each other,
**characterized in that**
said photovoltaic panels (31₁; 31₂; 31₃) are each one respectively a photovoltaic panel of Claim 1;
and **in that**
each one of said batteries (51₁, 51₂, ..., 51₈) is supplied with electric power individually by a string or by a combination of series and/or parallel connections of strings of one of the photovoltaic panels (31₁; 31₂; 31₃) themselves.
